# EUROPEAN PATENT APPLICATION

(11) **EP 4 516 960 A2**
(43) Date of publication of application: **05.03.2025**
(21) Application number: 24193474.4
(22) Date of filing: 08.08.2024
(51) Int. Cl.: C23C 16/02, C23C 16/26

(54) **METHOD AND SYSTEM FOR CO-DEPOSITED DIAMOND-LIKE CARBON COATINGS**

(30) Priority: 30.08.2023 US 202318239872
(71) Applicant: II-VI Delaware, Inc., Wilmington, DE 19890 (US)
(72) Inventor: HIMELINSKI, Stanley F., Wilmington, 19890 (US); MICHAUX, Domenic J., Wilmington, 19890 (US); SCHWARCZ, Daniel E., Wilmington, 19890 (US)
(74) Representative: Schmidt, Christian

(57) **Abstract**

Embodiments of the present disclosure may comprise a protective coating, the protective coating comprising a bottom layer, comprising substantially a first material, and a top layer, comprising substantially diamond-like carbon. There is a blended layer between the bottom layer and the top layer, comprising first material and diamond-like carbon in varying concentrations.

## Description

### TECHNICAL FIELD

The present disclosure generally relates to a method and system for co-deposited diamond-like carbon coatings.

### BACKGROUND

Aspects of the present disclosure relate to a method and system for co-deposited diamond-like carbon coatings. Various issues may exist with conventional solutions for diamond-like carbon coatings. In this regard, conventional systems and methods for diamond-like carbon coatings may be costly, cumbersome, and/or inefficient.

Limitations and disadvantages of conventional systems and methods will become apparent to one of skill in the art, through comparison of such approaches with some aspects of the present methods and systems set forth in the remainder of this disclosure with reference to the drawings.

### BRIEF SUMMARY OF THE DISCLOSURE

Shown in and/or described in connection with at least one of the figures, and set forth more completely in the claims are a method and system for co-deposited diamond-like carbon coatings.

These and other advantages, aspects and novel features of the present disclosure, as well as details of illustrated embodiments thereof, will be more fully understood from the following description and drawings.

### BRIEF DESCRIPTION OF THE DRAWINGS

The various features and advantages of the present disclosure may be more readily understood with reference to the following detailed description taken in conjunction with the accompanying drawings, wherein like reference numerals designate like structural elements.
FIG. 1 is an exemplary block diagram illustrating a protective coating in accordance with embodiments of this patent disclosure.
FIG. 2 is a schematic illustration of a cross-section of a protective coating according to embodiments of this patent disclosure.
FIG. 3 is a flow chart illustrating an exemplary method to form a protective coating according to embodiments of this patent disclosure.

### DETAILED DESCRIPTION

The following discussion provides various examples of method and system for co-deposited diamond-like carbon coatings. Such examples are non-limiting, and the scope of the appended claims should not be limited to the particular examples disclosed. In the following discussion, the terms "example" and "e.g.," are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "or" means any one or more of the items in the list joined by "or". As an example, "x or y" means any element of the three-element set {(x), (y), (x, y)}. As another example, "x, y, or z" means any element of the seven-element set {(x), (y), (z), (x, y), (x, z), (y, z), (x, y, z)}.

The terms "comprises," "comprising," "comprises," and/or "including," are "open ended" terms and specify the presence of stated features, but do not preclude the presence or addition of one or more other features.

The terms "first," "second," etc. may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

This patent disclosure relates to an application of a material referred to as Diamond-Like Carbon (DLC) coating. The nomenclature 'Diamond-Like Carbon' may be used to illustrate some of its characteristic, and its structural resemblance to natural diamond, presenting in terms of high hardness, low friction, and wear resistance. DLC may also be referred to as "hard carbon." The essential attribute that differentiates DLC from natural diamond, however, may be the amorphous nature of DLC, which may lead to a combination of sp2 (graphite-like) and sp3 (diamond-like) bonded carbon atoms.

DLC coatings may comprise a form of amorphous carbon material that may displays some of the typical properties of diamond. It may exhibit a combination of properties such as high hardness, low friction coefficient, high wear resistance, high corrosion resistance, and good electrical insulation. Due to the aforementioned properties, DLC coatings may have applicability in an array of applications.

One application of DLC coatings may comprise its use in the automotive industry where it is utilized in the coating of engine components to reduce friction and wear. The low friction and high wear resistance properties of DLC have made it a suitable candidate for application in the biomedical industry, particularly in artificial joint implants, cardiovascular devices, and surgical instruments. DLC coatings may also be desirable for solar panels.

DLC coatings may also be employed in the data storage industry. In addition, they may be used in the field of electronics and optoelectronics, where they may serve as a protective coating on semiconductors and in the optics industry, where they may reduce glare and act as anti-glare / anti-reflective coating for various materials.

DLC coatings may generally not adhere easily to other materials, however. DLC does not adhere to glass, for example. This may lead to adhesion problems, delamination, and coating / film failure. DLC coatings do adhere to various carbides, compounds of carbon and metal such as silicon carbide, and metalloids such as silicon and germanium. Thus, to adhere a DLC coating to some other coating may require a tacking layer or adhesive layer in between. For example, between a zinc selenide layer and a DLC coating, a germanium layer may be used as an adhesive layer. For example, such an adhesive layer may be 2 - 10 nanometers in thickness. In general, an adhesive layer may be any thickness that may be desirable to support the optical, physical or mechanical properties of the item being manufactured. In some instances, an additional adhesive layer may not be required because the DLC coating may adhere to the layer it is intended to be deposited on.

In accordance with various applications, some properties of the adhesive layer may be undesirable. For example, germanium may be opaque to certain wavelengths in the visible light spectrum, which may not be desirable in some applications.

Certain chemicals used in industrial manufacturing processes may attack the adhesive layer and may lead to the DLC coating to come off, delaminate, or fail. Accordingly, it may be advantageous for some applications to adhere a DLC coating without an adhesive layer.

In the realm of optics, DLC coatings may be appreciated for their anti-reflective attributes. Anti-reflective coatings may be indispensable in optical applications to increase the light transmission through lenses, and to reduce glare and unwanted reflections. Used appropriately, DLC coatings may also be used to improve reflectivity.

A DLC coating application onto optical components such as lenses, prisms, windows or semiconductors may reduce the amount of reflected light, thereby improving the optical performance of these components. The amorphous structure of the DLC coating, which may result from a mixture of sp2 and sp3 carbon bonds, may contribute to its anti-reflective property by mitigating the phase shift of light waves that pass through the optical component.

Another advantage of DLC coatings in the optics industry may be their high durability. Unlike conventional anti-reflective coatings that can be more easily scratched or damaged, DLC coatings may boast high hardness and wear resistance, thus significantly enhancing the lifespan of the optical components. Furthermore, the high corrosion resistance of DLC coatings may also prevent any damage to the optical components due to environmental factors.

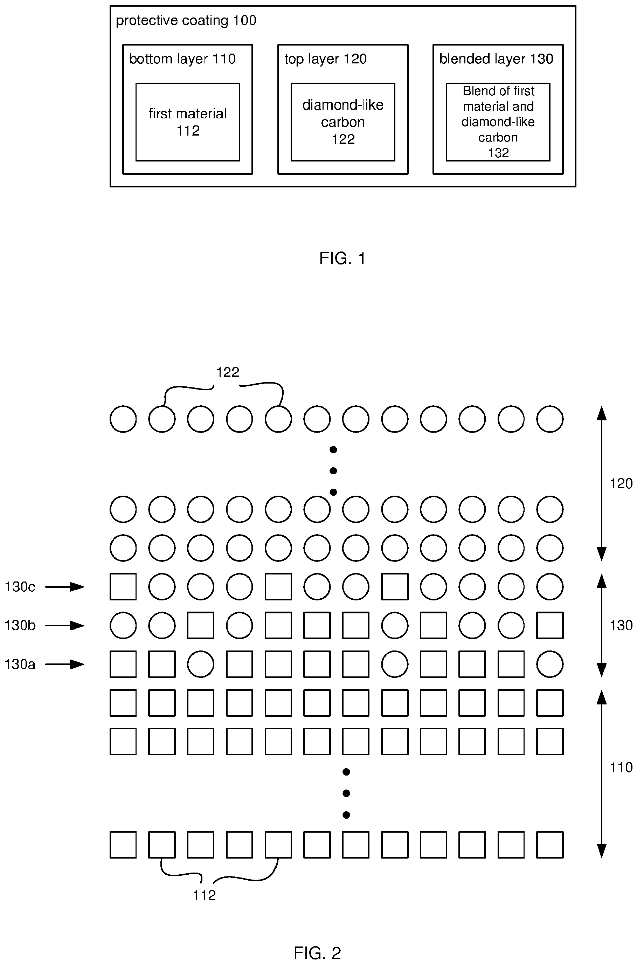

Referring now to FIG. 1, FIG. 1 is a block diagram that describes a protective coating 100, according to some embodiments of the present disclosure. The protective coating 100 may comprise a bottom layer 110 and a top layer 120. The protective coating 100 may also comprise a blended layer 130 between the bottom layer 110 and the top layer 120.

The bottom layer 110 may substantially comprise a first material 112 only. As will be clear to a person skilled in the art, "only" may refer to the bottom layer 110 comprising substantially a first material, but the bottom layer 110 may comprise certain pollutants, imperfections, residue of materials etc. as may be reasonably expected in an industrial manufacturing process, for example in the semiconductor and/or optics industry.

The top layer 120 may comprise a diamond-like carbon 122 only. As will be clear to a person skilled in the art, "only" may refer to the top layer 120 comprising substantially diamond-like carbon 122, but the top layer 120 may comprise certain pollutants, imperfections, residue of materials etc. as may be reasonably expected in an industrial manufacturing process, for example in the semiconductor and/or optics industry.

The blended layer 130 may comprise first material 112 and diamond-like carbon 122 in a blended material 132. The ratio in the blend 132 of a quantity of the first material 112 to a quantity of the diamond-like carbon 122 may decrease to zero within the blended layer 130 with increasing separation distance from the bottom layer 110.

In some embodiments, the first material 112 may be a metal or a dielectric. In some embodiments, the first material 112 may be any coating material other than diamond-like carbon. In some embodiments, the first material 112 may be ytterbium, fluoride, zinc sulfide, copper, silicon, germanium, diamond, glass, silicon carbide, or zinc selenide. In some embodiments, the diamond-like carbon 122 may comprise sp2-bonded and sp3-bonded carbon atoms. In some embodiments, the ratio may decrease monotonically. In some embodiments, the ratio may decrease from approximately 20/1, 10/1, or 5/1.

FIG. 2 illustrates an exemplary cross-section of a coating in accordance with the present disclosure. There is shown a bottom layer 110 comprising first material 112 (symbolized by squares), a top layer 120 comprising diamond-like carbon 122 (symbolized by circles). There is further shown a blended layer 130 comprising illustrative layers 130a, 130b, 130c. The illustrative blended layers 130 illustrate different ratios of first material 112 to diamond-like carbon 122. For example, 130a illustrates a ratio of first material 112 to diamond-like carbon 122 of 9/3=3:1, 130b illustrates a ratio of first material 112 to diamond-like carbon 122 of 6/6 = 1:1, 130c illustrates a ratio of first material 112 to diamond-like carbon 122 of 3/9=1:3. FIG. 2 illustrates how in the blended layer 130, the concentration of the first material 112 decreases and the concentration of the diamond-like carbon 122 increases with increasing distance from the bottom layer 110. The layers 130a, 130b, 130c may be associated with changing blends 132 (with distance from the bottom layer 110) of first material 112 and diamond-like carbon 122.

As will be clear to the person skilled in the art, FIG. 2 is an illustrative schematic. In practice, the number of layers may not be discrete and the dimensions of the layers as well as the ratios illustrated are merely illustrative of the applicable concepts.

Accordingly, in the blended layer 130, the first material 112 and the diamond-like carbon 122 are mixed in varying proportions, similar to a diffusion process. By establishing such a structure, the top layer 120 and the bottom layer 110 may adhere to each other through the blended layer 130. The blended layer 130, in that sense, is not a discrete layer like the top layer 120 and the bottom layer 110, but rather the blending together or entanglement of the top layer 120 and the bottom layer 110. For example, in such a case, it is not necessary to add a third material, for example germanium, as an adhesive layer between the top layer 120 and the bottom layer 130.

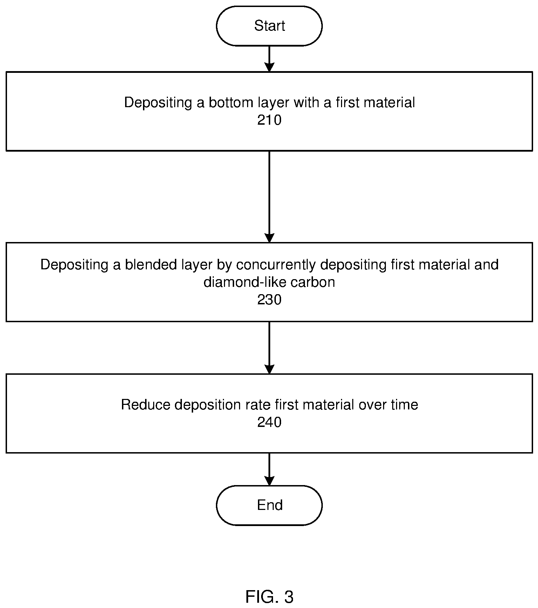

FIG. 3 is a flowchart that describes a method, according to some embodiments of the present disclosure. In some embodiments, at 210, the method may comprise depositing a bottom layer 110 with a first material 112. For example, the depositing of the bottom layer 110 may occur at an initial rate of, for example, 10 angstrom / second. It is clear to the persons skilled in the art, that the rate of deposition is merely exemplary and not limiting. After a desired thickness of the bottom layer 110 may have been reached, at step 230, diamond-like carbon 122 may start to be co-deposited, i.e., diamond-like carbon 122 may be deposited concurrently with the first material 112 to start forming the blended layer 130 comprising blends 132. For example, a diamond-like carbon 122 may be deposited at 2 angstrom / second. As will be clear to the person skilled in the art, the rate of deposition is merely exemplary and not limiting.

In order to decrease the quantity of the first material 112, at 240, as the codepositing takes place, the deposition rate of the first material 112 may be reduced over time while the deposition rate of the diamond-like carbon 122 may remain constant. Correspondingly, the ratio of first material 112 deposited over diamond-like carbon 122 deposited continues to decrease. When the deposition rate of the first material 112 eventually is reduced to zero, only the diamond-like carbon 122 and thus the DLC coating may continue to be deposited.

As will be clear to the person skilled in the art, the deposition ratio of the first material 112 over diamond-like carbon 122 may be varied by increasing, decreasing or keeping constant the deposition rate of either or both of the first material 112 and the diamond-like carbon 122.

In some embodiments, in step 240, the ratio of the first material 112 over the diamond-like material 122 may decrease monotonically. In some embodiments, the ratio may decrease from approximately 20/1, 10/1, or 5/1 down to (eventually) zero. In some embodiments, the depositing may be atomic layer deposition (ALD) or chemical vapor deposition (CVD) or thin-film deposition or physical vapor deposition (PVD) or plasma-assisted chemical vapor deposition (PACVD). In some embodiments, the depositing rates for the first material 112 and/or the diamond-like carbon 122 may be depositing rates of 1 to 12 angstrom /second, but is not so limited.

Implementations as described herein may relate to the following: A protective coating, the protective coating comprising a bottom layer, comprising substantially a first material, and a top layer, comprising substantially diamond-like carbon. There is a blended layer between the bottom layer and the top layer, comprising first material and diamond-like carbon in varying concentrations.

The present application claims priority of U.S. Patent Application No. 18/239,872, filed August 30, 2023. The entire disclosure of this application is hereby explicitly incorporated by reference into the present application.

The present disclosure comprises reference to certain examples; however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will comprise all examples falling within the scope of the appended claims.

## Claims

1. A protective coating, said protective coating comprising:
a bottom layer, comprising substantially a first material only;
a top layer, comprising substantially diamond-like carbon only;
a blended layer between said bottom layer and said top layer, further comprising:
first material and diamond-like carbon, wherein a ratio of a quantity of said first material to a quantity of said diamond-like carbon decreases to zero within said blended layer with increasing separation distance from said bottom layer.

2. The protective coating of claim 1, wherein said first material is a metal or a dielectric.

3. The protective coating of claim 1 or 2, wherein said first material is any coating material other than diamond-like carbon.

4. The protective coating of any one of claims 1 to 3, wherein said first material is ytterbium, fluoride, zinc sulfide, copper, silicon, germanium, diamond, glass, silicon carbide, or zinc selenide.

5. The protective coating of any one of claims 1 to 4, wherein said diamond-like carbon comprises sp2-bonded and sp3-bonded carbon atoms.

6. The protective coating of any one of claims 1 to 5, wherein said ratio decreases monotonically.

7. The protective coating of any one of claims 1 to 6, wherein said ratio decreases from approximately 20/1, 10/1, or 5/1.

8. A method to make a protective coating, said method comprising:
depositing a bottom layer, comprising substantially a first material only;
depositing a top layer, comprising substantially diamond-like carbon only;
depositing a blended layer between said bottom layer and said top layer,
further comprising
concurrently depositing first material and diamond-like carbon, wherein a ratio of a quantity of said first material deposited to a quantity of said diamond-like carbon deposited decreases to zero within said blended layer with increasing separation distance from said bottom layer.

9. The method of claim 8, wherein said first material is a metal or a dielectric.

10. The method of claim 8 or 9, wherein said first material is any coating material other than diamond-like carbon.

11. The method of any one of claims 8 to 10, wherein said first material is ytterbium, fluoride, zinc sulfide, copper, silicon, germanium, diamond, glass, silicon carbide, or zinc selenide.

12. The method of any one of claims 8 to 11, wherein said diamond-like carbon comprises sp2-bonded and sp3-bonded carbon atoms.

13. The method of any one of claims 8 to 12, wherein said ratio decreases monotonically.

14. The method of any one of claims 8 to 13, wherein said ratio decreases from approximately 20/1, 10/1, or 5/1.

15. The method of any one of claims 8 to 14, wherein said depositing is atomic layer deposition (ALD) or chemical vapor deposition (CVD) or thin-film deposition or physical vapor deposition (PVD), or plasma-assisted chemical vapor deposition (PACVD).

16. The method of any one of claims 8 to 15, wherein said depositing is a depositing rates of 1 to 12 angstrom / second.
